# EUROPEAN PATENT APPLICATION

(11) **EP 1 892 726 A2**
(43) Date of publication of application: **27.02.2008**
(21) Application number: 07114547.8
(22) Date of filing: 17.08.2007
(51) Int. Cl.: G11C 29/50, G11C 29/00

(54) **Semiconductor integrated circuit and test method thereof**

(30) Priority: 22.08.2006 JP 2006225020
(71) Applicant: FUJITSU LIMITED, Kawasaki-shi, Kanagawa 211-8588 (JP)
(72) Inventor: Yamaguchi, Shusaku, Kawasaki-shi, Kanagawa 211-8588 (JP)
(74) Representative: Kreutzer, Ulrich

(57) **Abstract**

A semiconductor integrated circuit (121) is provided which includes a laser fuse circuit (125) made to store a first trimming code (LF) by a laser radiation, an electric fuse circuit (126) made to store a second trimming code (EF) by a voltage application, and an adjusting circuit (123) adjusting an electric potential level or a timing depending on the first or second trimming code.

## Description

### BACKGROUND OF THE INVENTION

### [Field of the Invention]

The present invention relates to a semiconductor integrated circuit and a test method thereof.

### [Description of the Related Art]

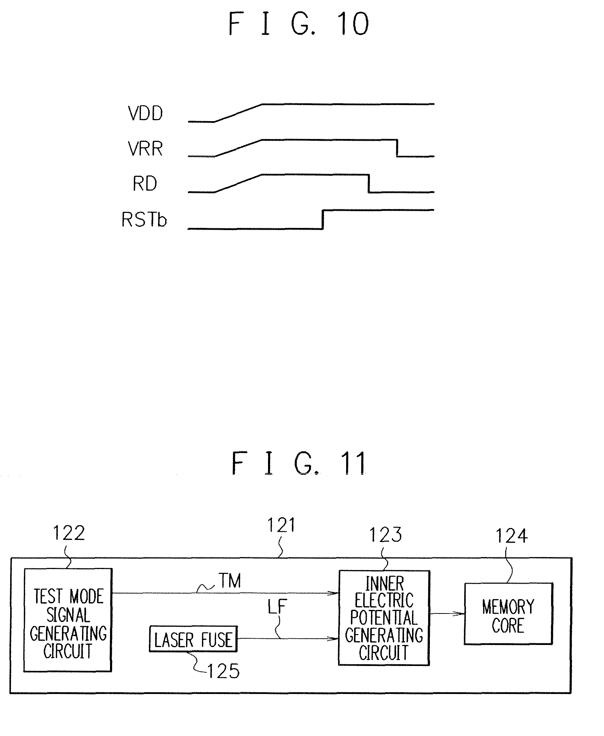

Fig. 11 is a diagram showing a structure example of a semiconductor memory chip 121. The semiconductor memory chip 121 includes a test mode signal generating circuit 122, a laser fuse circuit 125, an inner electric potential generating circuit 123 and a memory core (memory cell array) 124. The test mode signal generating circuit 122 includes a volatile memory, and outputs a trimming code TM as a test mode signal in the volatile memory. The trimming code TM is a signal for adjusting a level of an inner electric potential to a plus direction or a minus direction. The laser fuse circuit 125 is a nonvolatile memory having a laser fuse and outputs a trimming code LF similarly to the test mode signal generating circuit 122. The inner electric potential generating circuit 123 generates the inner electric potential depending on the trimming code TM or LF and supplies the inner electric potential to the memory core 124. The memory core 124 operates based on the inner electric potential and stores a plurality of data.

There are two tests for the semiconductor memory chip 121. One is a test before a laser fuse cutting process in the laser fuse circuit 125. The other is a test after the laser fuse cutting process in the laser fuse circuit 125. In the test before the laser fuse cutting process, the inner electric potential generating circuit 123 generates the inner electric potential based on the trimming code TM. In the test after the laser fuse cutting process, the inner electric potential generating circuit 123 generates the inner electric potential based on the trimming code LF.

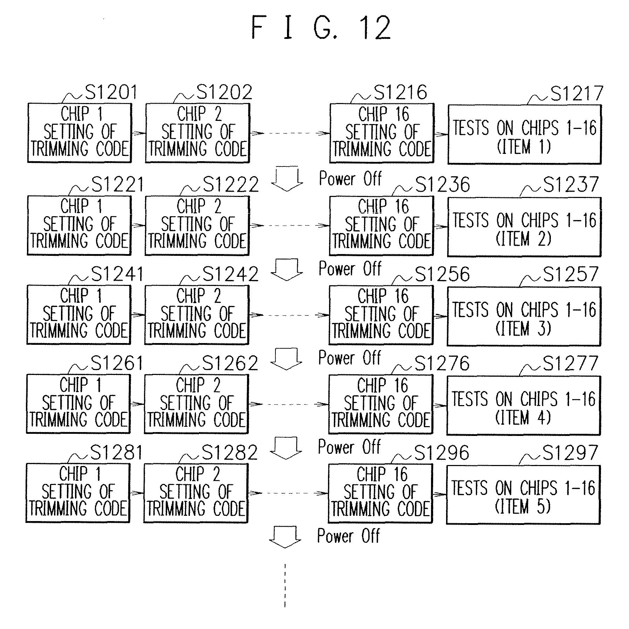

Fig. 12 is a diagram showing a test process example before the laser fuse cutting process. Hereinafter will be described an example in which sixteen, a first to sixteenth, semiconductor memory chips 121 on a semiconductor wafer are tested.

Steps S1201 to S1217 are tests for a first test item. First, in the step S1201, a tester sets the trimming code TM in the volatile memory in the test mode signal generating circuit 122 of the first semiconductor memory chip 121. Next, in the step S1202, the tester sets the trimming code TM in the volatile memory in the test mode signal generating circuit 122 of the second semiconductor memory chip 121. Next, the tester similarly sets the trimming codes TM in the volatile memories in the test mode signal generating circuits 122 of the third to fifteenth semiconductor memory chips 121. Lastly, in the step S1216, the tester sets the trimming code TM in the volatile memory in the test mode signal generating circuit 122 of the sixteenth semiconductor memory chip 121. Hereby, the first to sixteenth semiconductor memory chips 121 generate the inner electric potentials depending on the respective trimming codes TM and supply the inner electric potentials to memory cores 124. Next, in the step 1217, the tester performs the tests of the first test item on the first to sixteenth semiconductor memory chips 121.

When the tests of the first test item end, power supplies of all the semiconductor memory chips 121 are turned off for initialization. Then, the trimming codes TM stored by the volatile memories in the test mode signal generating circuits 122 are cleared. Next, the power supplies of all the semiconductor memory chips 121 are turned on again in order that tests of the second item are performed.

Next, steps S1221 to S1237 are tests for the second test item. First, in the step S1221, the tester sets the trimming code TM in the volatile memory in the test mode signal generating circuit 122 of the first semiconductor memory chip 121. Next, in the steps S1222 to S1236, the tester sets the trimming codes TM in the volatile memories in the test mode signal generating circuits 122 of the second to sixteenth semiconductor memory chips 121. Hereby, the first to sixteenth semiconductor memory chips 121 generate the inner electric potentials depending on the respective trimming codes TM and supply the inner electric potentials to the memory cores 124. Next, in the step 1237, the tester performs the tests of the second test item on the first to sixteenth semiconductor memory chips 121.

When the tests of the second test item end, the power supplies of all the semiconductor memory chips 121 are turned off for initialization. Then, the trimming codes TM stored by the volatile memories in the test mode signal generating circuits 122 are cleared. Next, the power supplies of all the semiconductor memory chips 121 are turned on again in order that tests of a third test item are performed.

Next, steps S1241 to S1257 are the tests for the third test item. First, in the steps S1241 to 1256, the tester sets the trimming codes TM in the volatile memories in the test mode signal generating circuits 122 of the first to sixteenth semiconductor memory chips 121. Hereby, the first to sixteenth semiconductor memory chips 121 generate the inner electric potentials depending on the respective trimming codes TM and supply the inner electric potentials to the memory cores 124. Next, in the step 1257, the tester performs tests of the third test item on the first to sixteenth semiconductor memory chips 121.

When the tests of the third test item end, the power supplies of all the semiconductor memory chips 121 are turned off for initialization. Then, the trimming codes TM stored by the volatile memories in the test mode signal generating circuits 122 are cleared. Next, the power supplies of all the semiconductor memory chips 121 are turned on again in order that tests of a fourth test item are performed.

Next, steps S1261 to S1277 are the tests for the fourth test item. First, in the steps S1261 to 1276, the tester sets the trimming codes TM in the volatile memories in the test mode signal generating circuits 122 of the first to sixteenth semiconductor memory chips 121. Hereby, the first to sixteenth semiconductor memory chips 121 generate the inner electric potentials depending on the respective trimming codes TM and supply the inner electric potentials to the memory cores 124. Next, in the step 1277, the tester performs the tests of the fourth test item on the first to sixteenth semiconductor memory chips 121.

When the tests of the fourth test item end, the power supplies of all the semiconductor memory chips 121 are turned off for initialization. Then, the trimming codes TM stored by the volatile memories in the test mode signal generating circuits 122 are cleared. Next, the power supplies of all the semiconductor memory chips 121 are turned on again in order that tests of a fifth test item are performed.

Next, steps S1281 to S1297 are the tests for the fifth test item. First, in the steps S1281 to 1296, the tester sets the trimming codes TM in the volatile memories in the test mode signal generating circuits 122 of the first to sixteenth semiconductor memory chips 121. Hereby, the first to sixteenth semiconductor memory chips 121 generate the inner electric potentials depending on the respective trimming codes TM and supply the inner electric potentials to the memory cores 124. Next, in the step 1297, the tester performs the tests of the fifth test item on the first to sixteenth semiconductor memory chips 121.

Hereinafter, similar processings are repeated by a number of test items as heretofore described. In the tests before the laser fuse cutting, a write/read test of the memory core 124 is performed for the purpose of detection of an address of a defective memory cell. On that occasion, it is desirable that the test is performed in a state that the inner electric potential is dependant on the trimming code LF. However, since the test is performed before the laser fuse cutting, the laser fuse circuit (nonvolatile ROM) 125 in the semiconductor memory chip 121 is not yet made to store an appropriate trimming code LF. Thus, the above-described write/read test is performed after the trimming code TM of the inner electric potential is stored in advance in a latch (volatile storage element) of the test mode signal generating circuit 122 in the semiconductor memory chip 121. Meanwhile, with miniaturization of the semiconductor memory, it is necessary to test quite numerous items. The test of each item is performed from an activation of the power supply and finally ends with a power cutoff.

In following Patent Document 1 is described a trimming circuit including a fuse part, a decoder part and a transistor group.

In following Patent Document 2 is described a delay time adjusting circuit including a selection fuse which is cut in response to a fuse cutting signal and a multiplexer which selects and outputs to a variable delay circuit either one of a delay control signal or a fuse code signal with being controlled by the selection fuse.

In following Patent Document 3 is described an on-chip circuit for cutting a fuse for a precision trimming analog integrated circuit sealed in a plastic package device.
[Patent Document 1] Japanese Patent Application Laid-open No. Hei 3-283638
[Patent Document 2] Japanese Patent Application Laid-open No. 2003-69397
[Patent Document3] Japanese Patent Application Laid-open No. Hei 7-183387

In the test before the laser fuse cutting, since the trimming code TM to be stored in the semiconductor memory chip 121 is different by each of sixteen semiconductor memory chips 121, operations of making the latches in the chips store the trimming codes TM are performed by a number of times equal to the number of the chips tested simultaneously before the tests of the respective items are performed. When the number of chips tested simultaneously is increased for a purpose of shortening a test time, there is a problem that a time spent for the operations of making the latches in the chips store the trimming codes TM becomes huge, resulting in an insufficient effect in shortening the time.

### SUMMARY OF THE INVENTION

A purpose of the present invention is to provide a semiconductor integrated circuit capable of shortening a test time and improving reliability, and a test method thereof.

According to a perspective of the present invention, a semiconductor integrated circuit is provided which includes a laser fuse circuit made to store a first trimming code by a laser radiation, an electric fuse circuit made to store a second trimming code by a voltage application, and an adjusting circuit adjusting an electric potential level or a timing depending the first or second trimming code.

### BRIEF DESCRIPTION OF THE DRAWINGS

Fig. 1 is a diagram showing a structure example of a semiconductor memory chip (semiconductor integrated circuit);
Fig. 2 is a diagram showing a test process example before a laser fuse cutting process;
Fig. 3 is a circuit diagram showing a structure example of a test mode signal generating circuit in the semiconductor memory chip;
Fig. 4 is a timing chart showing an operation example of the circuit of Fig. 3;
Fig. 5 is a circuit diagram showing a structure example of the test mode signal generating circuit to be connected to Fig. 3;
Fig. 6 is a diagram showing correspondence of an address signal and a kind of a trimming code;
Fig. 7 is a circuit diagram showing a structure example of a selector and an inner electric potential generating circuit of Fig. 1;
Fig. 8 is a circuit diagram showing a structure example of a trimming code decoder and selector of Fig. 7;
Fig. 9 is a diagram showing a structure example of an electric fuse circuit of Fig. 1;
Fig. 10 is a timing chart of the semiconductor memory chip including the electric fuse circuit at a time of an activation of a power supply;
Fig. 11 is a diagram showing a structure example of the semiconductor memory chip;
Fig. 12 is a diagram showing a test process example before the laser fuse cutting process;
Fig. 13 is a diagram showing a structure example of a semiconductor wafer;
Fig. 14 is a diagram showing a first semiconductor memory chip to a sixteenth semiconductor memory chip and a tester for testing the first semiconductor memory chip to the sixteenth semiconductor memory chip; and
Fig. 15 is a diagram showing a test process example of the semiconductor memory chip.

### DETAILED DESCRIPTION OF THE PREFERRED EMBODIMENTS

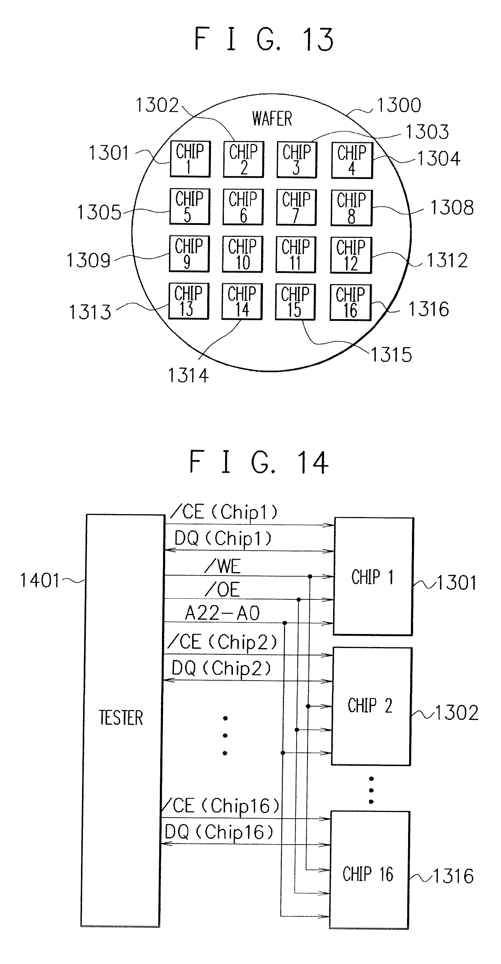

Fig. 13 is a diagram showing a structure example of a semiconductor wafer 1300 according to an embodiment of the present invention. On the semiconductor wafer 1300 are formed, for example, sixteen semiconductor memory chips of a first semiconductor memory chip 1301 to a sixteenth semiconductor memory chip 1316.

Fig. 14 is a diagram showing the first semiconductor memory chip 1301 to the sixteenth semiconductor memory chip 1316 and a tester 1401 for examining the first semiconductor memory chip 1301 to the sixteenth semiconductor memory chip 1316. The tester 1401 outputs a write enable signal /WE, an output enable signal /OE and address signals A0 to A22, these signals being common, to the sixteen semiconductor memory chips 1301 to 1316. Additionally, the tester 1401 outputs separate chip enable signals /CE and inputs and outputs separate data DQ per each of the sixteen semiconductor memory chips 1301 to 1316. The tester 1401 can test the sixteen semiconductor memory chips 1301 to 1316 simultaneously.

Tests are performed simultaneously on a plurality of the semiconductor memory chips 1301 to 1316 in a wafer state so that a test time is shortened. On this occasion, terminals of the address signals A0 to A22 and control terminals (/WE, /OE) determining write/read are connected to the tester 1401 in common among the plural semiconductor chips 1301 to 1316, so that a number of connection signals to the tester 1401 is decreased. Terminals of the data DQ are connected to the tester 1401 individually per each of the semiconductor memory chips 1301 to 1316, since it is necessary to perform a pass/fail judgment per each of the semiconductor memory chips 1301 to 1316. Additionally, chip selection control terminals (/CE) are connected to the tester 1401 individually per each of the semiconductor memory chips 1301 to 1316 in advance in order to enable a control per each of the semiconductor memory chips 1301 to 1316 in order that individual controls on each of the semiconductor memory chips 1301 to 1316 are possible.

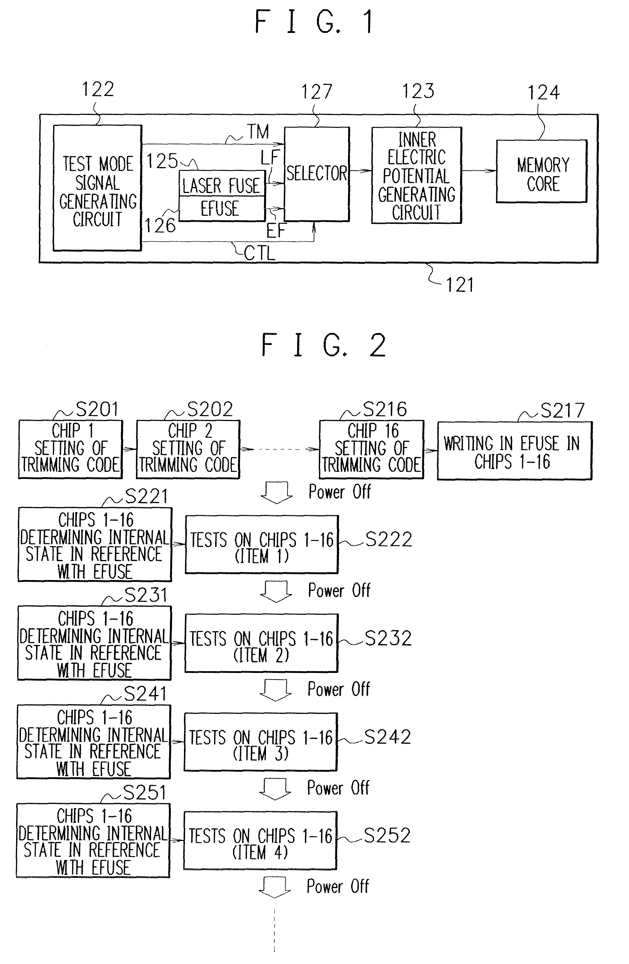

Fig. 1 is a diagram showing a structure example of a semiconductor memory chip (semiconductor integrated circuit) 121. The semiconductor memory chip 121 corresponds to the above-described semiconductor memory chips 1301 to 1316. Fig. 1 is a diagram in which an electric fuse (eFuse) circuit 126 and a selector 127 are added to Fig. 11.

The semiconductor memory chip 121 includes a test mode signal generating circuit 122, a laser fuse circuit 125, an electric fuse circuit 126, a selector 127, an inner electric potential generating circuit 123 and a memory core (memory cell array) 124. The test mode signal generating circuit 122 includes a volatile memory and outputs a trimming code TM as a test mode signal in the volatile memory. The trimming code TM is a signal for adjusting a level of an inner electric potential to a plus direction or a minus direction. The laser fuse circuit 125 is a nonvolatile memory including a laser fuse and stores and outputs a trimming code LF similarly to the test mode signal generating circuit 122. The electric fuse circuit 126 is a nonvolatile memory including an electric fuse and stores and outputs a trimming code EF similarly to the test mode signal generating circuit 122. The selector 127 inputs a control signal CTL from the test mode signal generating circuit 122 and selects either one of the trimming codes TM, LF and EF depending on the control signal CTL and outputs the trimming code to the inner electric potential generating circuit 123. The inner electric potential generating circuit 123 generates an inner electric potential depending on the trimming code outputted by the selector 127 and provides the inner electric potential to the memory core 124. The memory core 124 operates based on the inner electric potential and stores a plurality of data.

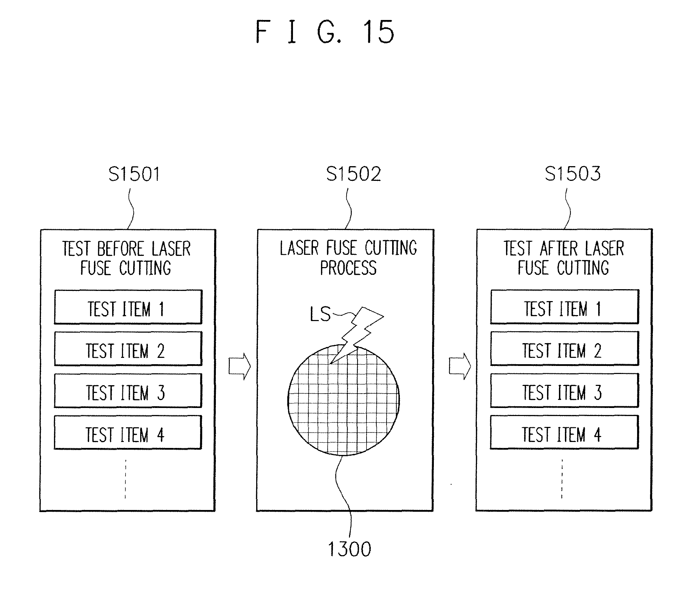

Fig. 15 is a diagram showing a test process example of the semiconductor memory chip 121. The laser fuse in the laser fuse circuit 125 can be cut by a laser radiation. It is possible to make the laser fuse store data (trimming code LF) depending on a cut state or a connected state of the laser fuse.

In a step S1501, tests on the semiconductor memory chip 121 are performed in the laser fuse circuit 125 in a semiconductor wafer state before a laser fuse cutting process. In these tests, numerous test items are tested. First, the electric fuse circuit 126 is made to store the trimming code EF. The electric fuse in the electric fuse circuit 126 can be cut by applying a high voltage on both ends thereof. It is possible to make the electric fuse store the trimming code EF depending on a cut state or a connected state of the electric fuse. A selector 127 selects and outputs the trimming code EF outputted by the electric fuse circuit 126. The inner electric potential generating circuit 123 generates the inner electric potential depending on the trimming code EF and supplies the inner electric potential to the memory core 124. The memory core 124 performs an operation for the test based on the inner electric potential.

Next, in a step S1502, the laser fuse cutting process is performed. More specifically, a laser LS is radiated to the semiconductor memory chip 121 on the semiconductor wafer 1300 to make the laser fuse of the laser fuse circuit 125 in the semiconductor memory chip 121 store the trimming code LF.

Next, in a step S1503, tests on the semiconductor memory chip 121 are performed in the semiconductor wafer state after the laser fuse cutting process. The selector 127 selects and outputs the trimming code LF outputted by the laser fuse circuit 125. The inner electric potential generating circuit 123 generates the inner electric potential depending on the trimming code LF and supplies the inner electric potential to the memory core 124. A memory core 124 performs an operation for the test based on the inner electric potential.

Meanwhile, in the semiconductor memory chip 121, a defective memory cell in the memory core 124 can be replaced with another redundant memory cell by using the laser fuse circuit 125. The laser fuse is a nonvolatile ROM performing writing by being cut by means of radiating a laser on a wiring layer. For example, the laser fuse can be made to store "0" in an uncut state, that is in an electrically conductive state, and to store "1" in a cut state, that is in an electrically unconductive state. By making the laser fuse store the address of the defective memory cell, the above-described replacement is performed. Meanwhile, in the inner electric potential generating circuit 123, a generated voltage value is deviated from an expected voltage value due to an effect of variation of transistor characteristics in a semiconductor wafer surface. Thus, also by the laser fuse circuit 125, the trimming code LF is made stored in the semiconductor memory chip, and a trimming is performed per each of the semiconductor memory chips.

Under the circumstances, as tests on the semiconductor memory chip in the wafer state, there are tests of two steps S1501 and S1503. The step S1501 is the test before the laser fuse cutting, and there are performed detection of the address of the defective memory cell and detection of a trimming value of the inner electric potential, and selection of the semiconductor memory chip in which the replacement with the redundant memory cell is impossible /trimming is impossible. The step S1503 is the test after the laser fuse cutting, and there is performed checking that the defective memory cell is replaced with the redundant memory cell so that normal write/read can be carried out, that the inner electric potential is the expected electric potential, and so forth.

Fig. 2 is a diagram showing a test process example before the laser fuse cutting process of the step S1501. First, in a step S201 the tester 1401 sets the trimming code EF for the electric fuse circuit 126 in the first semiconductor memory chip 1301. More specifically, a flip-flop in the electric fuse circuit 126 is made to store the trimming code EF. Next, in a step S202, the tester 1401 sets the trimming code EF for the electric fuse circuit 126 in the second semiconductor memory chip 1302. Next, the tester 1401 similarly sets the trimming codes EF for the electric fuse circuits 126 in the third semiconductor memory chip 1303 to the fifteenth semiconductor memory chip 1315. Next, in a step S216, the tester 1401 sets the trimming code EF for the electric fuse circut126 in the sixteenth semiconductor memory chip 1316. Since the trimming codes EF are different by each of the semiconductor memory chips 1301 to 1316, the trimming codes are set individually. Next, in a step S217, the tester 1401 directs the electric fuses of the electric fuse circuits 126 in the first semiconductor memory chip 1301 to the sixteenth semiconductor memory chip 1316 to write the above-described trimming codes EF. Hereby, the semiconductor memory chips 1301 to 1316 perform writing of the trimming codes EF. In the electric fuse circuits 126, the trimming codes EF are stored.

When the above-describe writing to the electric fuses ends, power supplies of all the semiconductor memory chips 1301 to 1316 are turned off for initialization. Since the electric fuse in the electric fuse circuit 126 is the nonvolatile memory, storage of the trimming code EF is maintained even if the power supply is turned off. Next, in order to perform tests of a first test item, the power supplies of all the semiconductor memory chips 1301 to 1316 are turned on again.

Next, in a step S221, the first semiconductor memory chip 1301 to the sixteenth semiconductor memory chip 1316 generate inner electric potentials depending on the trimming codes EF stored by the electric fuse circuits 126 and supply the inner electric potentials to the memory cores 124. Next, in a step S222, the tester 1401 performs tests of the first test item on the first semiconductor memory chip 1301 to the sixteenth semiconductor memory chip 1316.

When the tests of the first test item end, the power supplies of all the semiconductor memory chips 1301 to 1316 are turned off for initialization. Since the electric fuse in the electric fuse circuit 126 is the nonvolatile memory, storage of the trimming code EF is maintained even if the power supply is turned off. Next, in order to perform tests of a second test item, the power supplies of all the semiconductor memory chips 1301 to 1316 are turned on again.

Next, in a step S231, the first semiconductor memory chip 1301 to the sixteenth semiconductor memory chip 1316 generate the inner electric potentials depending on the trimming codes EF stored by the electric fuse circuits 126 and supply the inner electric potentials to the memory cores 124. Next, in a step S232, the tester 1401 performs tests of the second test item on the first semiconductor memory chip 1301 to the sixteenth semiconductor memory chip 1316.

When the tests of the second test item end, the power supplies of all the semiconductor memory chips 1301 to 1316 are turned off for initialization. Since the electric fuse in the electric fuse circuit 126 is the nonvolatile memory, storage of the trimming code EF is maintained even if the power supply is turned off. Next, in order to perform tests of a third test item, the power supplies of all the semiconductor memory chips 1301 to 1316 are turned on again.

Next, in a step S241, the first semiconductor memory chip 1301 to the sixteenth semiconductor memory chip 1316 generate the inner electric potentials depending on the trimming codes EF stored by the electric fuse circuits 126 and supply the inner electric potentials to the memory cores 124. Next, in a step S242, the tester 1401 performs tests of the third test item on the first semiconductor memory chip 1301 to the sixteenth semiconductor memory chip 1316.

When the tests of the third test item end, the power supplies of all the semiconductor memory chips 1301 to 1316 are turned off for initialization. Since the electric fuse in the electric fuse circuit 126 is the nonvolatile memory, storage of the trimming code EF is maintained even if the power supply is turned off. Next, in order to perform tests of a fourth test item, the power supplies of all the semiconductor memory chips 1301 to 1316 are turned on again.

Next, in a step S251, the first semiconductor memory chip 1301 to the sixteenth semiconductor memory chip 1316 generate the inner electric potentials depending on the trimming codes EF stored by the electric fuse circuits 126 and supply the inner electric potentials to the memory cores 124. Next, in a step S252, the tester 1401 performs tests of the fourth test item on the first semiconductor memory chip 1301 to the sixteenth semiconductor memory chi 1316.

Hereinafter, similar processings are repeated by a number of test items as heretofore described. In the tests before the laser fuse cutting, a write/read test of the memory core 124 is performed for a purpose of detecting the address of the defective memory cell. On that occasion, it is desirable that the test is performed in a state that the inner electric potential is dependant on the trimming code LF. However, since the test is performed before the laser fuse cutting, the laser fuse circuit (nonvolatile ROM) 125 in the semiconductor memory chip 121 is not yet made to store an appropriate trimming code LF. Thus, the above-described write/read test is performed after the electric fuse circuit 126 is made to store the trimming code EF of the inner electric potential in advance.

In Fig. 12, since the trimming codes TM are set for the sixteen semiconductor memory chips per each of the test items, the test time is long. In the present embodiment, by making the electric fuse circuit 126 being the nonvolatile memory store the trimming code EF, storage of the trimming code EF can be maintained even if the power supply is turned off per each of the test items, and it is not necessary to set the trimming codes per each of the test items. Hereby, in the present embodiment, the test time can be shortened compared to in a case of Fig. 12.

The test time can be shortened by mounting the electric fuse circuit 126 made to store the trimming code EF on the semiconductor memory chip to omit a processing of making a latch in the semiconductor memory chip store the trimming code at a time of starting the test of each item. Meanwhile, since the electric fuse circuit 126 uses the inner electric potential for a reading operation of a stored value, the electric fuse circuit 126 is not suitable for storing the trimming code of the inner electric potential. In other words, it is afraid that the inner electric potential becomes higher than an expected electric potential soon after activation since the trimming code EF is read after the inner electric potential is generated, and there is a problem in reliability. This problem can be evaded by the selector 127 selecting the trimming code LF of the laser fuse circuit 125 and generating the inner electric potential depending on the trimming code LF, after the laser fuse cutting.

Since the electric fuse circuit 126 is the nonvolatile memory, once the trimming code EF is stored, storage of the trimming code EF can be maintained even if the power supply is turned off thereafter. Therefore, it is possible to shorten a test time of a semiconductor integrated circuit which requires numerous test items, so that a reliable and inexpensive semiconductor integrated circuit can be provided.

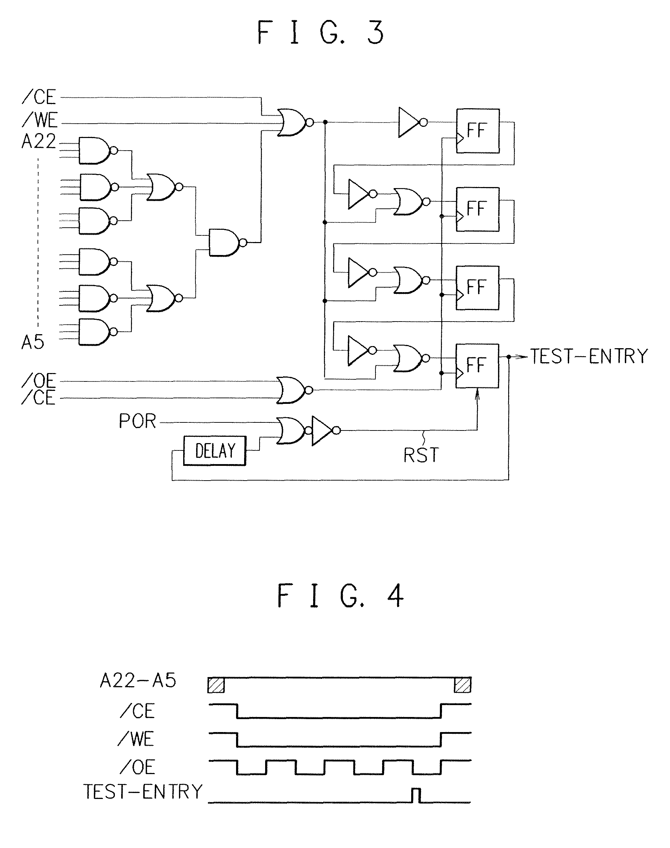

Fig. 3 is a circuit diagram showing a structure example of the test mode signal generating circuit 122 in the semiconductor memory chip 121, while Fig. 4 is a timing chart showing an operation example thereof. The tester 1401 controls trimming code selection of the selector 127 by supplying signals A5 to A22, /CE, /WE and /OE to the test mode signal generating circuit 122. In order to control the trimming code selection, the address signals A5 to A22 are made to be "1" (high level), the chip enable signal /CE is made to be low level, the write enable signal /WE is made to be low level and four pulses are inputted as the output enable signal /OE. A power-on reset signal POR is a signal having a pulse of high level at a time of power-on. A reset signal RST resets four flip-flops (FF) by the power-on reset signal POR. The flip-flop of a final stage outputs a pulse of high level as a signal TEST-ENTRY, by the four pulses of the output enable signal /OE.

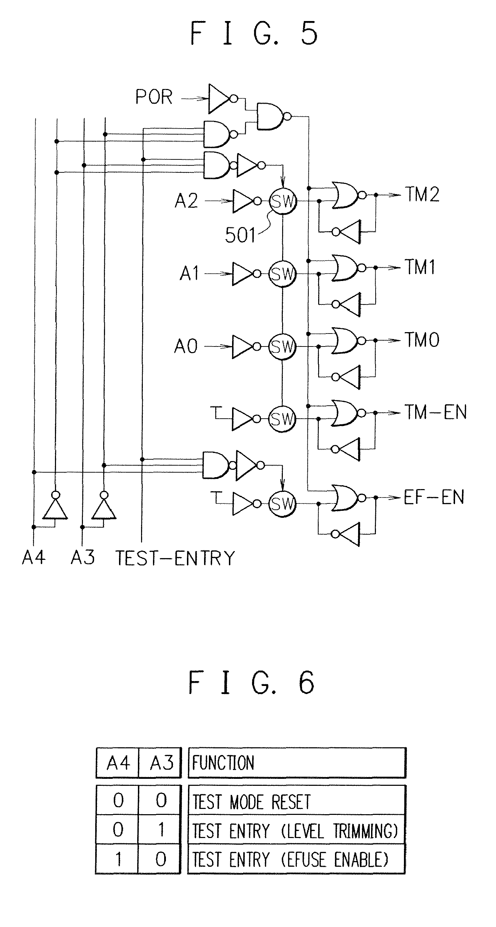

Fig. 5 is a circuit diagram showing a structure example of the test mode signal generating circuit 122 connected to Fig. 3, while Fig. 6 is a diagram showing correspondence of the address signal and the kind of the trimming code.

When the address signals A3 and A4 are "0" (low level), a test mode is reset and a test mode enable signal TM-EN and an electric fuse enable signal EF-EN become low level, so that the selector 127 selects the trimming code LF of the laser fuse circuit 125 as will be described later.

When the address signal A3 is "1" (high level) and the address signal A4 is "0" (low level), entry to the test mode is made. Then the test mode enable signal TM-EN becomes high level and the electric fuse enable signal EF-EN becomes low level, so that the selector 127 selects the trimming code TM of the test mode signal generating circuit 122 as will be described later. This trimming code TM is, for example, trimming codes TM0 to TM2 of three bits. The address signals A0 to A2 of three bits which the tester 1401 outputs are outputted as the trimming codes TM0 to TM2 of three bits. A switch 501 closes when a control signal becomes high level.

When the address signal A3 is "0" (low level) and the address signal A4 is "1" (high level), entry to the test mode is made. Then the test mode enable signal TM-EN becomes low level and the electric fuse enable signal EF-EN becomes high level, so that the selector 127 selects the trimming code EF of the electric fuse circuit 126 as will be described later.

Incidentally, the signals TM0 to TM2, TM-EN and EF-EN are reset to be low level by the power-on reset signal POR at a time of power-on.

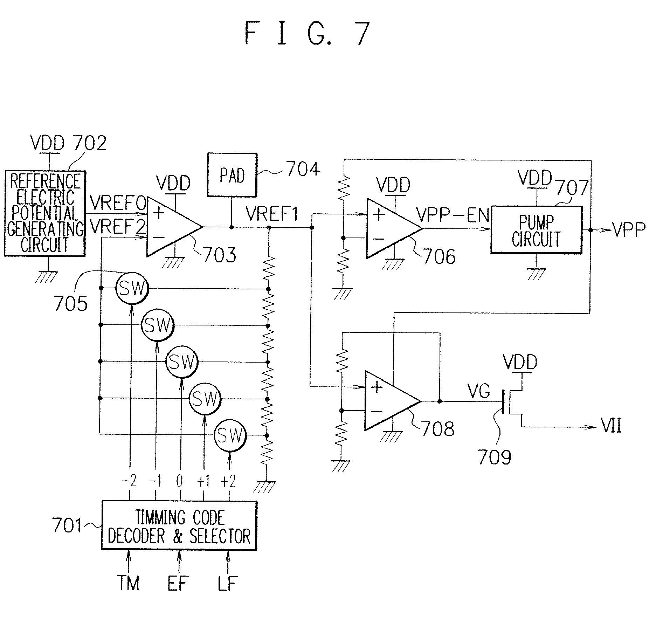

Fig. 7 is a circuit diagram showing a structure example of the selector 127 and the inner electric potential generating circuit 123 of Fig. 1. A trimming code decoder and selector 701 corresponds to the selector 127 of Fig. 1, while the other circuits correspond to the inner electric potential generating circuit 123 of Fig. 1.

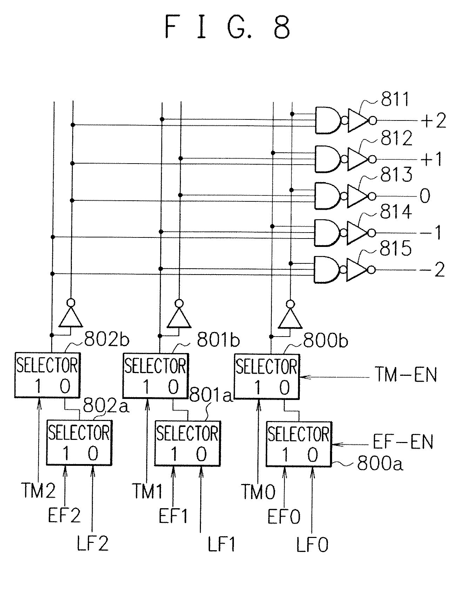

The trimming code decoder and selector 701 selects, decodes and outputs the trimming code LF when the signals TM-EN and EF-EN of Fig. 5 are low level, selects, decodes and outputs the trimming code TM when the signal TM-EN is high level, and selects, decodes and outputs the trimming code EF when the signal EF-EN is high level. On this occasion, the trimming code decoder and selector 701 decodes the trimming code and makes either one of signals showing "-2", "-1", "0", "+1" or "+2" high level and outputs the signal to the switch 705. Details of the trimming code decoder and selector 701 will be described later with reference to Fig. 8.

The switch 705 closes when a high level signal is inputted from the trimming code decoder and selector 701, and opens when a low level signal is inputted. The signal of "-2" means lowering the inner electric potential by two levels, the signal of "-1" means lowering the inner electric potential by one level, the signal of "0" means that level adjustment of the inner electric potential is plus/minus zero, the signal of "+1" means raising the inner electric potential by one level and the signal of "+2" means raising the inner electric potential by two levels.

A reference electric potential generating circuit 702 receives supply of a power supply voltage VDD and generates a reference electric potential VREF0. A comparator 703 inputs the reference electric potential VREF0 to a plus input terminal and inputs an electric potential VREF2 from the switch 705 to a minus input terminal, and outputs a reference electric potential VREF1. On this occasion, the comparator 703 outputs the reference electric potential VREF1 such that the input potentials VREF0 and VREF2 become equal.

For example, in a case that the trimming code decoder and selector 701 makes the output signal of "0" high level, the electric potential VREF2 becomes half the reference electric potential VREF1 by resistance division. For example, when the reference electric potential VREF0 is 0.5V, the comparator 703 outputs the reference electric potential VREF1 such that the electric potential VREF2 becomes 0.5V, the same as VREF0. As a result, the reference electric potential VREF1 becomes 1V. Incidentally, the tester 1401 can input the reference electric potential VREF1 or detect the reference electric potential VREF1 via a pad 704.

A comparator 706 inputs an electric potential which is resistance-divided from the reference electric potential VREF1 and an output voltage of a pump circuit 707, and outputs an electric potential VPP-EN. The pump circuit 707 boosts a voltage depending on the electric potential VPP-EN and outputs an inner electric potential VPP. The inner electric potential VPP can be made higher than the power supply voltage VDD. For example, when the reference electric potential VREF1 is 1V, the inner electric potential VPP can be made to be 3V by setting a resistance ratio of the resistance division to be 2:1.

Additionally, a comparator 708 inputs an electric potential which is resistance-divided from the reference electric potential VREF1 and an output electric potential VG, and outputs the electric potential VG. In an n-channel field-effect transistor 709, a gate is connected to a line of the electric potential VG, a drain is connected to a terminal of the power supply electric potential VDD and a source is connected to a terminal of an inner electric potential VII. The transistor 709 can generate the electric potential VII which is lower than the power supply voltage VDD.

As stated above, the inner electric potentials VPP and VII can be generated based on the power supply voltage VDD depending on the trimming codes. For example, the power supply voltage VDD is 1.8V, the inner electric potential VPP is 3V and the inner electric potential VII is 1.6V.

Fig. 8 is a circuit diagram showing a structure example of the trimming code decoder and selector 701 of Fig. 7. Trimming codes TM0 to TM2 of three bits correspond to the trimming code TM of Fig. 7, trimming codes EF0 to EF2 of three bits correspond to the trimming code EF of Fig. 7 and trimming codes LF0 to LF2 of three bits correspond to the trimming code LF of Fig. 7.

A selector 800a selects and outputs the trimming code EF0 when the enable signal EF-EN is "1" and selects and outputs the trimming code LF0 when the enable signal EF-EN is "0".

A selector 800b selects and outputs the trimming code TM0 when the enable signal TM-EN is "1" and selects and outputs the trimming code EF0 or LF0 outputted by the selector 800a when the enable signal TM-EN is "0".

A selector 801a selects and outputs the trimming code EF1 when the enable signal EF-EN is "1" and selects and outputs the trimming code LF1 when the enable signal EF-EN is "0".

A selector 801b selects and outputs the trimming code TM1 when the enable signal TM-EN is "1" and selects and outputs the trimming code EF1 or LF1 outputted by the selector 801a when the enable signal TM-EN is "0".

A selector 802a selects and outputs the trimming code EF2 when the enable signal EF-EN is "1" and selects and outputs the trimming code LF2 when the enable signal EF-EN is "0".

A selector 802b selects and outputs the trimming code TM2 when the enable signal TM-EN is "1" and selects and outputs the trimming code EF2 or LF2 outputted by the selector 802a when the enable signal TM-EN is "0".

A NOT circuit 811 outputs a signal showing "+2", a NOT circuit 812 outputs a signal showing "+1", a NOT circuit 813 outputs a signal showing "0", a NOT circuit 814 outputs a signal showing "-1" and a NOT circuit 815 outputs a signal showing "-2".

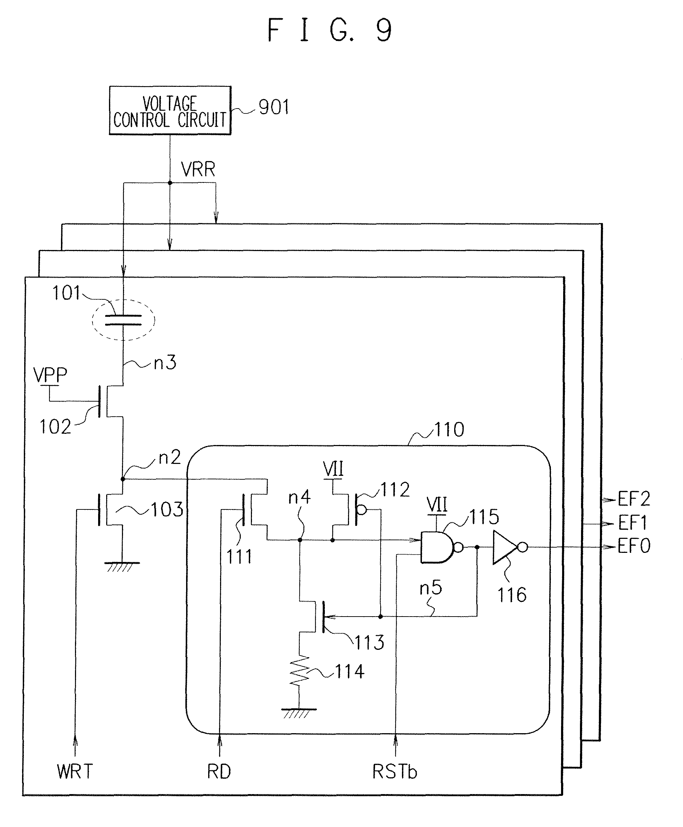

Fig. 9 is a diagram showing a structure example of the electric fuse circuit 126 of Fig. 1. The electric fuse circuit 126 includes three electric fuse circuits and the three electric fuse circuit store and output the trimming codes EF0 to EF2 of three bits. A voltage control circuit 901 generates a voltage VRR and supplies the voltage VRR to the three electric fuse circuits. Hereinafter, structure examples of the respective electric fuse circuits will be described.

Hereinafter, the field-effect transistor is referred to simply as a transistor. An electric fuse capacitor 101 is connected to between the voltage VRR and a node 3. An n-channel transistor 102 is a protective transistor, in which a gate is connected to a voltage (inner electric potential) VPP, a drain is connected to the node n3 and a source is connected to a node n2. The voltage VPP is 3V, for example. An n-channel transistor 103 is a write circuit, in which a gate is connected to a write signal WRT, a drain is connected to the node n2 and a source is connected to a ground.

Next, a structure of a read circuit 110 will be described. In an n-channel transistor 111, a gate is connected to a read signal RD, a drain is connected to the node n2 and a source is connected to a node n4. In an n-channel transistor 113, a gate is connected to a node n5, a drain is connected to the node 4 and a source is connected to a ground via a resistor 114. In a p-channel transistor 112, a gate is connected to the node n5, a source is connected to a voltage (inner electric potential) VII and a drain is connected to the node n4. The voltage VII is 1.6V, for example. In a NAND circuit 115, which is connected to a power supply voltage VII, an input terminal is connected to the node n4 and a line of a signal RSTb and an output terminal is connected to the node n5. In a NOT circuit 116, an input terminal is connected to the node n5 and an output terminal is connected to lines of the signals EF0, EF1 or EF2. Hereinafter, an example with the signal EF0 will be explained.

When the write signal WRT becomes high level, the transistor 103 turns on. A high voltage VRR (8V, for example) is applied to the capacitor 101. The electric fuse is constituted with the capacitor 101 and is in electrically unconductive state when in a state that nothing is done. When a high voltage (8V, for example) is applied to between both terminals of the capacitor 101, an insulating film of the capacitor 101 is destroyed and the capacitor 101 becomes in an electrically conductive state. These two states are allotted to data "0" and "1". For example, when the capacitor 101 is electrically unconductive in a state that the insulating film of the capacitor 101 is not destroyed, the state is allotted to "0". When the capacitor 101 is electrically conductive in a state that the insulating film is destroyed, the state is allotted to "1". The capacitor 101 can be used as the nonvolatile ROM.

A write operation to the capacitor (electric fuse) 101 will be described. First, the voltage control circuit 901 boosts the voltage VRR of the capacitor 101 to a high voltage (8V, for example). At this time, since another terminal node n3 of the capacitor 101 is in a floating state, an electric potential of the node n3 also rises. In this state, a difference of the electric potentials between both terminals of the capacitor 101 is still small. Thereafter, the write signal WRT is made high level to turn on the writing transistor 103, and with the node n3 being a ground, a high voltage is applied to between the both electrodes of the capacitor 101, so that the insulating film of the capacitor 101 is destroyed. In contrast, when the write signal WRT is low level, the node n3 is still in the floating state, and the high voltage is not applied to between the both terminals of the capacitor 101 so that the capacitor 101 maintains the unconductive state.

Fig. 10 is a timing chart at a time of a power supply activation of the semiconductor memory chip 121 including the electric fuse circuit 126. A power supply voltage VDD is a power supply voltage of the semiconductor memory chip and is 1.8 V, for example. The voltages VDD, VRR and RD gradually rise by the activation of the power supply. Soon, the voltage VRR maintains approximately 1.6V. A signal RSTb maintains low level. In Fig. 9, when the signal RSTb is low level, the node n5 becomes high level. Then the transistor 112 is turned off and the transistor 113 is turned on. As a result, the node n4 changes from in a floating state to low level. Thereafter, the signal RSTb changes from low level to high level. When the capacitor 101 is in the conductive state, the node n4 becomes high level and the output signal EF0 becomes high level. In contrast, when the capacitor 101 is in the unconductive state, the node n4 becomes low level and the output signal EF0 becomes low level. Thereafter, the voltage VRR and the read signal RD become grounds, the transistor 111 is turned off and the output signal EF0 is maintained. The read circuit 110 outputs the state of the capacitor 101 as the signal EF0 by the above-described operation.

It should be noted that though the example that the inner electric potential generating circuit (adjusting circuit) 123 adjusts the inner electric potential level depending on the trimming code, the adjusting circuit 123 may adjust a timing of the signal of the memory core 124 depending on the trimming code.

Since the electric fuse circuit is the nonvolatile memory, once the first trimming code is stored, storage of the first trimming code can be maintained even if the power supply is turned off thereafter. Therefore, it is possible to shorten a test time of a semiconductor integrated circuit which requires numerous test items, so that a reliable and inexpensive semiconductor integrated circuit can be provided.

The present embodiments are to be considered in all respects as illustrative and no restrictive, and all changes which come within the meaning and range of equivalency of the claims are therefore intended to be embraced therein. The invention may be embodied in other specific forms without departing from the spirit or essential characteristics thereof.

## Claims

1. A semiconductor integrated circuit (121), comprising:
a laser fuse circuit (125) made to store a first trimming code (LF) by a laser radiation;
an electric fuse circuit (126) made to store a second trimming code (EF) by a voltage application; and
an adjusting circuit (123) adjusting an electric potential level or a timing depending on the first or second trimming code.

2. The semiconductor integrated circuit according to claim 1,
further comprising a selector (127) selecting the first trimming code (LF) stored by said laser fuse circuit (125) or the second trimming code (EF) stored by said electric fuse circuit (126), and
wherein said adjusting circuit (123) adjust the electric potential level or the timing depending on the first or the second trimming code selected by said selector (127).

3. The semiconductor integrated circuit according to claim 2,
wherein said selector (127) selects the second trimming code (EF) before said laser fuse circuit (125) is made to store the first trimming code (LF) by the laser radiation.

4. The semiconductor integrated circuit according to claim 3,
wherein said selector selects (127) the first trimming code (LF) after said laser fuse circuit (125) is made to store the first trimming code by the laser radiation.

5. The semiconductor integrated circuit according to claim 1,
wherein said selector (127) selects either one of the first trimming code (LF), the second trimming code (EF) and a third trimming code inputted from the outside, and
wherein said adjusting circuit adjusts the electric potential level or the timing depending on the first, second or third trimming code selected by said selector.

6. The semiconductor integrated circuit according to claim 1,
wherein said adjusting circuit (127) adjusts the electric potential level depending on the first (LF) or second (EF) trimming code.

7. The semiconductor integrated circuit according to claim 6, further comprising a memory cell array (124) storing a plurality of data using an electric potential adjusted by said adjusting circuit.

8. A test method of the semiconductor integrated circuit according to claim 1, the method comprising:
a voltage application step (S1501) of making the electric fuse circuit (126) store the second trimming code (EF) by a voltage application;
a first test step of performing a first test by adjusting an electric potential level or a timing depending on the second trimming code after said voltage application step;
a laser radiation step (S1502) of making the laser fuse circuit (125) store the first trimming code (LF) by a laser radiation after said first test step (S1501); and
a second test step (S1503) of performing a second test by adjusting an electric potential level or a timing depending on the first trimming code (LF) after said laser application step (S1502).

9. The test method of the semiconductor integrated circuit according to claim 8,
wherein said voltage application step (S1501) is able to make the plurality of semiconductor integrated circuits (1301-1316) on a semiconductor wafer (1300) store separate second trimming codes (EF).

10. The test method of the semiconductor integrated circuit according to claim 8,
wherein said first test step turns off a power supply of the semiconductor integrated circuit every time the test of the respective test items ends, when tests of a plurality of test items are performed.
